# FASCICULE DE BREVET EUROPEEN

(11) **EP 3 672 384 B1**
(45) Date de publication et mention de la délivrance du brevet: **26.02.2025**
(21) Numéro de dépôt: 19213495.5
(22) Date de dépôt: 04.12.2019
(51) Int. Cl.: H05K 7/20, H01L 23/473, H05K 7/14

(54) **ENSEMBLE ELECTRIQUE D'UNE BARRE DE CONNEXION ELECTRIQUE ET D'UN MODULE DE REFROIDISSEMENT**
ELEKTRISCHE ANORDNUNG VON EINER ELEKTRISCHEN STROMSCHIENE UND EINES KÜHLMODULS
ELECTRICAL ASSEMBLY OF AN ELECTRICAL BUSBAR AND A COOLING MODULE

(30) Priorité: 21.12.2018 FR 1873994
(43) Date de publication de la demande: 24.06.2020
(73) Titulaire: Valeo Electrification, 95800 Cergy (FR)
(72) Inventeur: POUILLY, Aurélien, 78300 POISSY (FR); LEGENDRE, Alexandre, 95280 JOUY-LE-MOUTIER (FR)
(74) Mandataire: Valeo Powertrain Systems

(56) Documents cités:
- WO-A1-2013/136877
- DE-A1- 102016 218 151
- US-A1- 2004 256 710
- US-A1- 2017 201 083

## Description

### DOMAINE TECHNIQUE DE L'INVENTION

La présente invention se rapporte au domaine des équipements électriques, notamment pour véhicule, tels que des onduleurs.

Plus précisément, la présente invention vise un sous-ensemble de tels équipements, à savoir un ensemble électrique formé sur un module de refroidissement et comportant une barre de connexion électrique.

### ETAT DE LA TECHNIQUE

Dans de nombreux équipements électriques, notamment des équipements électriques de puissance tels que des onduleurs destinés à alimenter en énergie un moteur électrique de véhicule, il est prévu des modules de refroidissement.

Un module de refroidissement, comme cela est connu, sert à évacuer de la chaleur produite par des composants électriques, tels que des cartes électroniques ou des éléments capacitifs en particulier.

Un module de refroidissement actif fait intervenir un corps extérieur, en particulier un liquide de refroidissement tel que de l'eau par exemple, dont la circulation, entre une entrée et une sortie du module de refroidissement, ledit module de refroidissement étant disposé à proximité ou au contact d'au moins un élément à refroidir, permet d'abaisser la température dudit élément à refroidir.

Un module de refroidissement passif, également désigné un dissipateur thermique, ne fait pas intervenir de corps extérieur. Un dissipateur thermique est généralement constitué d'un matériau présentant une bonne conductivité thermique. Il peut comprendre des éléments de radiateur, des ailettes, destinés à favoriser la dissipation de chaleur.

Dans un équipement électrique tel qu'un onduleur de puissance, on recourt à un module de refroidissement actif. Dans la suite, on désigne par l'expression « module de refroidissement » un module de refroidissement actif.

D'un autre côté, dans les procédés d'assemblage d'équipements électriques, il est aujourd'hui recherché une modularité améliorée, notamment afin de faciliter l'assemblage en recourant à des sous-ensembles indépendants d'un seul tenant.

Le document US2004/256710A1 propose un dispositif avec des composants semi-conducteurs de puissance fixé sur une face d'un corps de support refroidi, dont l'autre face porte un condensateur réservoir. Des barres conductrices, en plus des composants semi-conducteurs de puissance, sont fixées au corps de support refroidi.

Dans ce contexte, la présente invention vise un ensemble électrique formé sur un module de refroidissement dont une portion reçoit, directement fixée audit module, une barre de connexion électrique notamment destinée à recevoir au moins un connecteur électrique d'un équipement électrique tiers. Par exemple, dans le contexte d'un onduleur de véhicule, ladite barre de connexion électrique peut être une barre de connexion électrique alternative, également désignée « AC busbar » en anglais, destinée à recevoir des connecteurs de phase d'un moteur électrique du véhicule.

### PRESENTATION DE L'INVENTION

A cette fin, la présente invention vise un ensemble électrique comprenant un module de refroidissement, notamment un module de refroidissement actif comprenant un réseau de circulation de liquide de refroidissement, et une barre de connexion électrique, ladite barre de connexion électrique étant directement fixée à une portion de réception du module de refroidissement, ledit ensemble électrique étant destiné à être rapporté dans un châssis d'un premier équipement électrique.

Selon un mode de réalisation, la barre de connexion électrique est vissée sur la portion de réception du module de refroidissement.

Selon l'invention, un module électronique de puissance fixé sur une première surface du module de refroidissement et un élément capacitif de liaison fixé sur une seconde surface, opposée à la première surface, du module de refroidissement.

Selon un mode de réalisation, ladite portion de réception comprend des faces opposées qui sont respectivement dans le même plan que la première surface du module de refroidissement et que la deuxième surface du module de refroidissement.

Selon l'invention, le module de refroidissement comporte une première portion comprenant la première et la deuxième surface, et dans lequel ladite portion de réception forme une fourche s'étendant depuis la première portion du module de refroidissement.

La barre de connexion électrique selon l'invention comprend :
- une première partie maintenue entre deux bras de la fourche.
Selon un mode de réalisation, elle comporte aussi:
- un bras transversal s'étendant depuis un côté de la première partie, ledit bras transversal étant situé à la jonction de la fourche avec la première portion du module de refroidissement, ledit bras transversal s'étendant le long de la première surface du module de refroidissement et comprenant des bornes de connexion qui viennent en vis-à-vis de bornes dudit module de puissance pour y être connectées.

Selon un mode de réalisation, le module de refroidissement comporte une entrée de liquide de refroidissement et une sortie de liquide de refroidissement, le module de refroidissement étant configuré de sorte que le liquide de refroidissement circule entre le module électronique de puissance et l'élément capacitif de liaison.

Selon un mode de réalisation, la barre de connexion électrique comprend un corps en matériau isolant électrique maintenant ensemble des conducteurs de la barre de connexion électrique, ledit corps venant contre le module de refroidissement de manière à permettre une dissipation thermique de la chaleur des conducteurs vers le module de refroidissement.

La présente invention vise aussi un équipement électrique comprenant un boîtier dans lequel est logé un ensemble électrique tel que brièvement décrit ci-dessus.

Selon un mode de réalisation, ledit équipement électrique forme un onduleur.

### PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :
Fig. 1 : la figure 1 représente un exemple d'ensemble électrique selon l'invention ;
Fig. 2 : la figure 2 représente l'exemple d'ensemble électrique selon l'invention précédent, auquel est fixé un module électronique de puissance et un élément capacitif de liaison ;
Fig. 3 : la figure 3 montre un exemple d'équipement électrique, en l'espèce un onduleur, comprenant un ensemble électrique selon un exemple de l'invention ;
Fig. 4 : la figure 4 montre un module de refroidissement destiné à un ensemble électrique selon un exemple de l'invention ;
Fig. 5 : la figure 5 montre une barre de connexion électrique destinée à un ensemble électrique selon un exemple de l'invention.

Il faut noter que les figures exposent l'invention de manière détaillée pour mettre en œuvre l'invention, lesdites figures pouvant bien entendu servir à mieux définir l'invention le cas échéant.

### DESCRIPTION DETAILLEE DE L'INVENTION

Dans la description qui sera faite ci-après, l'invention sera décrite principalement en vue de la réalisation d'un onduleur, notamment destiné à alimenter une machine électrique telle qu'une machine électrique tournante d'un système de motorisation d'un véhicule. Toutefois, l'invention vise également tout équipement électrique apte à comprendre un ensemble électrique tel que décrit ci-après.

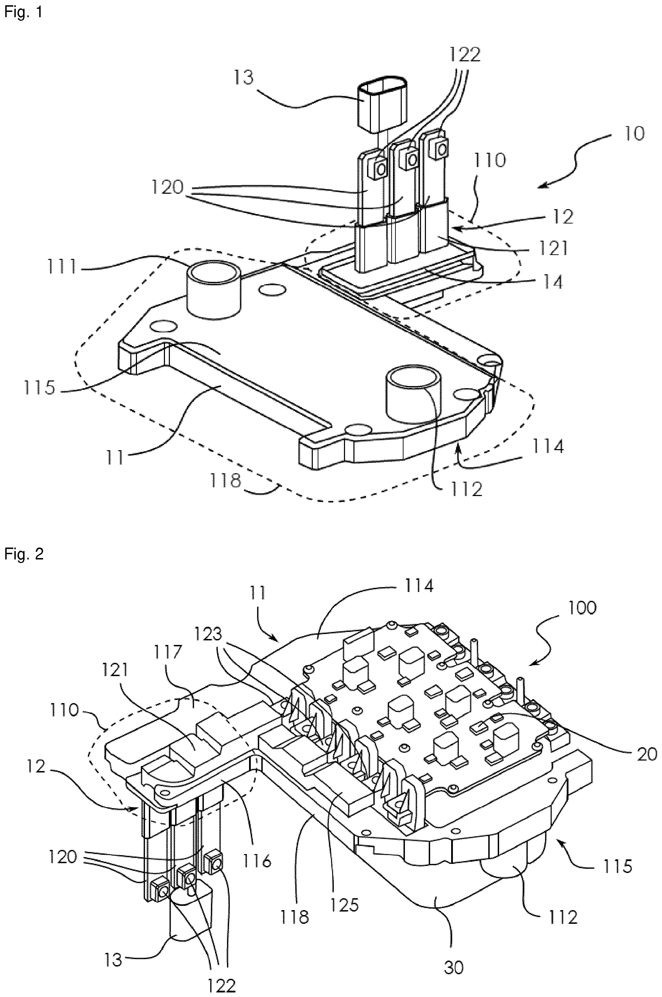

En référence à la figure 1, il est proposé un ensemble électrique 10 comprenant un module de refroidissement 11 dont une portion de réception 110 reçoit, directement fixée audit module de refroidissement 11, une barre de connexion électrique 12.

Par exemple, la barre de connexion électrique 12 est vissée au module de refroidissement 11. Alternativement, la barre de connexion électrique 12 peut être fixée au module de refroidissement par bouterollage ou par encastrement via des godrons, ou par tout autre moyen.

Un premier avantage réside dans le fait que le contact direct entre la barre de connexion électrique 12 et le module de refroidissement 11 permet de refroidir la barre de connexion électrique 12. En effet, en utilisation de l'équipement électrique auquel se rapporte l'ensemble électrique 10, lorsque la barre de connexion électrique 12 reçoit des connecteurs électriques, par exemple des connecteurs de phase d'un moteur électrique de véhicule lorsque l'équipement électrique est un onduleur de puissance d'un véhicule, un échauffement de ladite barre de connexion électrique 12 se produit.

Dans le même contexte, la barre de connexion électrique 12 comprend également des conducteurs électriques 120 avec des bornes 122 destinées être connectées à des bornes correspondantes d'un équipement électrique tiers, par exemple un moteur, ce qui participe à produire un échauffement de la barre de connexion électrique 12.

La portion de réception 110 s'étend depuis une première portion 118 du module de refroidissement 11, ladite première portion 118 présentant une première surface 114 et une deuxième surface 115, lesdites première et deuxième surfaces 114, 115 étant destinées à recevoir respectivement, toujours selon l'exemple évoqué ci-dessus, un module électronique de puissance et un élément capacitif de liaison.

Plus précisément, comme représenté à la figure 2, la barre de connexion électrique 12 comprend des conducteurs électriques 120, notamment, selon un mode de réalisation, des conducteurs plats de type « leadframes » selon le terme en anglais couramment utilisé. Des bornes électriques123 des conducteurs électriques 120 sont destinées, à une extrémité de la barre de connexion électrique 12, à être reçus par des bornes électriques d'un dispositif électrique tel qu'un module électronique de puissance 20 d'un onduleur, ledit module électronique de puissance 20 étant fixé au module de refroidissement 11 et refroidi par ce dernier. Selon ce mode de réalisation, d'autre part, la barre de connexion électrique 12, à l'extrémité opposée à la première extrémité, comprend des bornes électriques 122 destinées à recevoir des connecteurs de phase d'un moteur électrique alimenté par l'onduleur via le module électronique de puissance 20.

Comme représenté à la figure 1, le module de refroidissement 11 comporte par exemple une entrée 111 de liquide de refroidissement et une sortie 112 de liquide de refroidissement.

Ainsi, notamment, le liquide de refroidissement circule dans des canaux situés entre les première et deuxième surface 114, 115 du module de refroidissement 11. L'entrée 111 et la sortie 112 de liquide de refroidissement sont par exemple aménagées dans la deuxième surface 115 du module de refroidissement 11, c'est-à-dire sur la surface à laquelle est fixé l'élément capacitif de liaison 30, du côté opposé à la première surface 114 à laquelle est fixé le module électronique de puissance 20 sur la figure 2.

La barre de connexion électrique 12 peut comprendre un module de transmission 13. Le module de transmission 13, intégré dans la barre de connexion électrique 1, est notamment configuré pour se connecter à un connecteur électrique d'un équipement électrique pour prélever un signal électrique représentatif d'une propriété physique dudit dispositif électrique. Un tel équipement électrique est par exemple un moteur électrique contrôlé par le module électronique de puissance 20, le module de transmission 13 transmettant un signal représentatif de la position du moteur vers par exemple une carte de contrôle de l'onduleur.

Selon un mode de réalisation, un corps 121 en matériau isolant électrique est prévu dans la barre de connexion électrique 12 pour maintenir ensemble les conducteurs électriques 120, et les isoler électriquement entre leurs bornes électriques 122, 123. Cependant, le corps peut être en un matériau favorisant les échanges thermiques avec le module de refroidissement 11. Notamment, le corps 121 peut être surmoulé, collé, ou monté en force sur les conducteurs électriques 120, avant que la barre de connexion électrique 12 ne soit rapportée et fixée sur ledit module de refroidissement 11, au niveau de la portion de réception.

En outre, il est précisé qu'une interface thermique peut également être rapportée entre la barre de connexion électrique 12 et le module de refroidissement 11, en particulier le long du corps 21 de la barre de connexion électrique 12. Une telle interface thermique peut être constituée d'un matériau de type TIM (pour « Thermal Interface Material » signifiant matériau d'interface thermique).

Comme représenté sur la figure 1, l'ensemble électrique 10, comprenant le module de refroidissement 12 et la barre de connexion électrique 12 fixée sur une portion de réception 110 dudit module de refroidissement 11, permet d'améliorer la rigidité de ladite barre de connexion électrique 12.

Un joint d'étanchéité 14 peut être maintenu en position sur le corps 21, autour de la barre de connexion 12 pour venir, notamment contre un châssis de l'équipement électrique lorsque les conducteur électriques 120 traversent une ouverture du châssis pour se connecter à un équipement électrique tiers, notamment un moteur électrique.

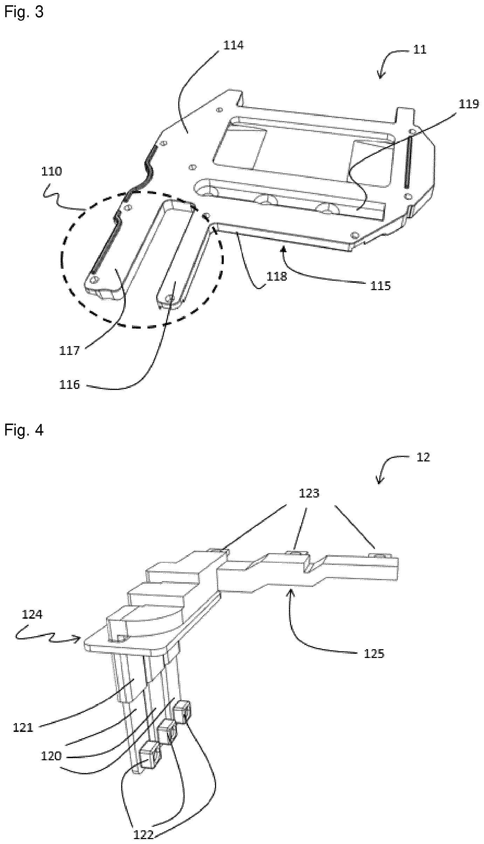

La figure 3 représente, isolément, un module de refroidissement 11, tel que destiné à faire partie d'un ensemble électrique selon un exemple de l'invention. La figure 4 représente, isolément, une barre de connexion 12 complémentaire, tel que destinée à faire partie d'un ensemble électrique selon le même exemple de l'invention.

De façon détaillée, selon le mode de réalisation représenté sur la figure 3, le module de refroidissement 11 présente une première portion 118 et une portion de réception 110. La première portion 118 comprend la première surface 114 et la deuxième surface 115. La portion de réception 110 comprend des faces opposées qui sont respectivement dans le même plan que la première surface 114 du module de refroidissement 11 et que la deuxième surface 115 du module de refroidissement 11. Le module de refroidissement 11 peut comprendre une cavité 119 destinée à recevoir des capteurs de courant mesurant les courants entre le module électronique de puissance 20 et la barre de connexion électrique 12. Les capteurs de courants comprennent par exemple des C-magnétiques 40 (visibles sur la figure 2).

En outre, toujours selon le mode de réalisation de la figure 3, conformément à l'invention, la portion de réception 110 forme une fourche s'étendant depuis la première portion 118 du module de refroidissement 11, ladite fourche comprenant deux bras 116, 117.

En référence à la figure 4, la barre de connexion électrique 12, de façon correspondante, comprend une première partie 124 destinée à être maintenue entre les deux bras 116, 117 de la fourche qui forme la portion de réception 110 (comme représenté par ailleurs sur la figure 2). La barre de connexion électrique 12 comprend par ailleurs un bras transversal 125 s'étendant depuis un côté de la première partie 124, ledit bras transversal 125 étant destiné à se situer à la jonction de la fourche avec la première portion 118 du module de refroidissement 11. Le bras transversal 125 s'étend le long de la première surface 114 du module de refroidissement 11 et comprend les bornes de connexion 123 qui sont destinées à se trouver en vis-à-vis de bornes d'un module de puissance 20 fixé sur ladite première surface 114 du module de refroidissement 11, pour y être connectées (comme représenté par ailleurs sur la figure 2).

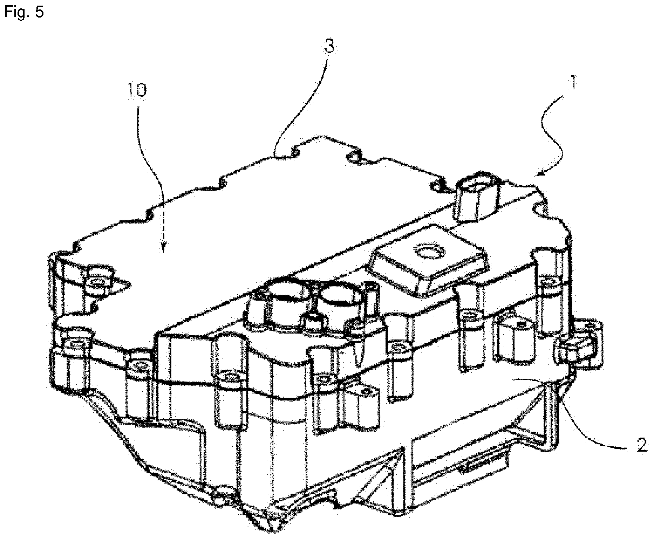

En référence à la figure 5, l'ensemble électrique 10 selon l'invention est destiné à être intégré dans un équipement électrique 1, en particulier un onduleur.

L'équipement électrique comprend un ensemble électrique 10 selon l'invention, avec un module de refroidissement et une barre de connexion électrique, ledit module de refroidissement étant pris en sandwich entre un module électronique de puissance 20 et un élément capacitif de liaison 30.

Sur la figure 5, il est représenté un châssis 2 à l'intérieur duquel est logé un ensemble électrique 10, notamment équipé d'un module électronique de puissance et d'un élément capacitif de liaison, ledit châssis 2 étant fermé par un couvercle 3.

En particulier, un module électronique de puissance 20 est un ensemble comprenant une pluralité de puces semi-conductrices formant un circuit électrique encapsulées dans une même enveloppe. Plus précisément, dans le cas présent, le module électronique de puissance 20, comme représenté sur la figure 2, peut être un ensemble comprenant des composants par lesquels passe de l'énergie alimentant une machine électrique, par exemple un moteur électrique, lesdits composants étant notamment destinés à transformer un courant continu en courants alternatifs ou vice-versa. Un tel module électronique de puissance 20 est configuré pour permettre un passage commandé d'énergie électrique entre une batterie d'alimentation haute tension et la machine électrique.

En outre, par « élément capacitif de liaison » 30, on entend un élément capacitif, également désigné « DC-link capacitor » en anglais, assurant une fonction de filtrage notamment pour fonction stabiliser de la tension fournie au module électronique de puissance.

Ainsi, le module de refroidissement 11 est d'abord configuré pour refroidir, d'une part, le module électronique de puissance 20 et, d'autre part, l'élément capacitif de liaison 30.

Selon l'invention, le module de refroidissement 11 refroidit également la barre de connexion électrique 12.

Dans le mode de réalisation selon lequel l'équipement électrique 1 est un onduleur, la barre de connexion électrique 12 est en particulier une barre de connexion alternative, destinée à recevoir des connecteurs de phase d'un moteur électrique alimenté en énergie par ledit onduleur, notamment au niveau des bornes électriques 122 situées à la deuxième extrémité de la barre de connexion 120.

Selon l'invention, le module de refroidissement 11 assure ainsi une fonction de support sur lequel on assemble et on maintient la barre de connexion électrique 12.

En outre, l'ensemble électrique 10 selon l'invention permet d'intégrer la barre de connexion électrique 12 dans l'asservissement du refroidissement de l'équipement électrique auquel se rapporte ledit ensemble électrique.

Le module de refroidissement 11, au sein de l'ensemble électrique 10 qu'il forme avec la barre de connexion électrique 12, assure, vis-à-vis de ladite barre de connexion électrique 12, à la fois une fonction de refroidissement et une fonction de rigidification.

Concernant la fonction de rigidification, il est précisé que l'amélioration est par exemple obtenue du fait de la fixation directe de la barre de connexion électrique 12 au module de refroidissement 11.

Il est également précisé qu'un avantage de l'invention réside dans le fait que l'ensemble électrique 10, comprenant le module de refroidissement 11 et la barre de connexion électrique 12, fixée audit module de refroidissement, notamment par vissage, est d'un seul tenant. Ledit ensemble électrique 10 constitue par conséquent un ensemble indépendant dont les fonctions peuvent être testées séparément.

En particulier, sur la base de l'ensemble électrique 10 selon l'invention, on peut assembler un module électronique de puissance 20 et un élément capacitif de liaison 30 pour former un sous-ensemble d'onduleur 100.

Un tel sous-ensemble d'onduleur 100 peut être testé de façon indépendante, ce qui améliore la modularité d'un procédé d'assemblage d'onduleurs.

Une fois testé de façon indépendante, l'ensemble électrique 10 de base ou le sous-ensemble d'onduleur 100 peut être rapporté dans un châssis 2 fermé par un couvercle 3 pour former un équipement électrique 1, tel qu'un onduleur.

## Revendications

1. Ensemble électrique (10) comprenant un module de refroidissement (11), notamment un module de refroidissement (11) actif comprenant un réseau de circulation de liquide de refroidissement, et une barre de connexion électrique (12), ladite barre de connexion électrique (12) étant directement fixée à une portion de réception (110) du module de refroidissement (11), ledit ensemble électrique (10) étant destiné à être rapporté dans un châssis (2) d'un premier équipement électrique (1) ledit ensemble électrique comprenant par ailleurs un module électronique de puissance (20) fixé sur une première surface (114) du module de refroidissement (11) et un élément capacitif de liaison (30) fixé sur une seconde surface (115), opposée à la première surface (114), du module de refroidissement (11),
le module de refroidissement comportant une première portion (118) comprenant la première et la deuxième surface (114, 115),
ensemble **caractérisé en ce que**
ladite portion de réception (110) forme une fourche s'étendant depuis la première portion (118) du module de
refroidissement (11), la barre de connexion électrique (12) comprenant une première partie (124) maintenue entre deux bras (116,117) de la fourche.

2. Ensemble selon la revendication 1, dans lequel ladite portion de réception (110) comprend des faces opposées qui sont respectivement dans le même plan que la première surface (114) du module de refroidissement (11) et que la deuxième surface (115) du module de refroidissement (11).

3. Ensemble électrique selon la revendication 1 ou 2, dans lequel la barre de connexion électrique (12) comprend un bras transversal (125) s'étendant depuis un côté de la première partie (124),ledit bras transversal (125) étant situé à la jonction de la fourche avec la première portion (118) du module de refroidissement (11),
ledit bras transversal (125) s'étendant le long de la première surface du module de refroidissement (11) et comprenant des bornes de connexion (123) qui viennent en vis-à-vis de bornes dudit module de puissance (20) pour y être connectées.

4. Ensemble électrique (10) selon l'une des revendications précédentes, dans lequel le module de refroidissement (11) comporte une entrée (111) de liquide de refroidissement et une sortie (112) de liquide de refroidissement, le module de refroidissement (11) étant configuré de sorte que le liquide de refroidissement circule entre le module électronique de puissance (20) et l'élément capacitif de liaison (30).

5. Ensemble électrique (10) selon l'une des revendications précédentes, dans lequel la barre de connexion électrique (12) comprend un corps (121) en matériau isolant électrique maintenant ensemble des conducteurs (122, 123) de la barre de connexion électrique (12), ledit corps (121) venant contre le module de refroidissement (11) de manière à permettre une dissipation thermique de la chaleur des conducteurs (122, 123) vers le module de refroidissement (11).

6. Equipement électrique (1) comprenant un boîtier (2) dans lequel est logé un ensemble électrique (10) selon l'une des revendications précédentes.

7. Equipement électrique (1) selon la revendication 6 formant un onduleur.

## Patentansprüche

1. Elektrische Anordnung (10), die ein Kühlmodul (11), insbesondere ein aktives Kühlmodul (11), das ein Netz zur Zirkulation einer Kühlflüssigkeit beinhaltet, und eine elektrische Stromschiene (12) beinhaltet, wobei die elektrische Stromschiene (12) direkt an einem Aufnahmeabschnitt (110) des Kühlmoduls (11) befestigt ist, wobei die elektrische Anordnung (10) dazu bestimmt ist, in ein Gestell (2) einer ersten elektrischen Ausrüstung (1) eingebracht zu werden,
wobei die elektrische Anordnung ferner ein elektronisches Leistungsmodul (20), das auf einer ersten Oberfläche (114) des Kühlmoduls (11) befestigt ist, und ein kapazitives Verbindungselement (30), das auf einer zweiten Oberfläche (115), die der ersten Oberfläche (114) gegenüberliegt, des Kühlmoduls (11) befestigt ist, beinhaltet,
wobei das Kühlmodul einen ersten Abschnitt (118) umfasst, der die erste und die zweite Oberfläche (114, 115) beinhaltet,
wobei die Anordnung **dadurch gekennzeichnet ist, dass** der Aufnahmeabschnitt (110) eine Gabel bildet, die sich von dem ersten Abschnitt (118) des Kühlmoduls (11) erstreckt, wobei die elektrische Stromschiene (12) einen ersten Teil (124) beinhaltet, der zwischen zwei Armen (116, 117) der Gabel gehalten wird.

2. Anordnung nach Anspruch 1, wobei der Aufnahmeabschnitt (110) gegenüberliegende Flächen beinhaltet, die sich jeweils in derselben Ebene wie die erste Oberfläche (114) des Kühlmoduls (11) bzw. die zweite Oberfläche (115) des Kühlmoduls (11) befinden.

3. Elektrische Anordnung nach Anspruch 1 oder 2, wobei die elektrische Stromschiene (12) einen Querarm (125) beinhaltet, der sich von einer Seite des ersten Teils (124) erstreckt, wobei sich der Querarm (125) an dem Übergang von der Gabel zu dem ersten Abschnitt (118) des Kühlmoduls (11) befindet,
wobei sich der Querarm (125) entlang der ersten Oberfläche des Kühlmoduls (11) erstreckt und Verbindungsanschlüsse (123) beinhaltet, die gegenüber von Anschlüssen des Leistungsmoduls (20) zu liegen kommen, um mit diesen verbunden zu werden.

4. Elektrische Anordnung (10) nach einem der vorhergehenden Ansprüche, wobei das Kühlmodul (11) einen Eingang (111) für Kühlflüssigkeit und einen Ausgang (112) für Kühlflüssigkeit umfasst, wobei das Kühlmodul (11) so konfiguriert ist, dass die Kühlflüssigkeit zwischen dem elektronischen Leistungsmodul (20) und dem kapazitiven Verbindungselement (30) zirkuliert.

5. Elektrische Anordnung (10) nach einem der vorhergehenden Ansprüche, wobei die elektrische Stromschiene (12) einen Körper (121) aus elektrisch isolierendem Material beinhaltet, der Leiter (122, 123) der elektrischen Stromschiene (12) zusammenhält, wobei der Körper (121) an dem Kühlmodul (11) zu liegen kommt, um eine thermische Ableitung der Wärme der Leiter (122, 123) hin zu dem Kühlmodul (11) zu ermöglichen.

6. Elektrische Ausrüstung (1), die ein Gehäuse (2) beinhaltet, in dem eine elektrische Anordnung (10) nach einem der vorhergehenden Ansprüche aufgenommen ist.

7. Elektrische Ausrüstung (1) nach Anspruch 6, die einen Wechselrichter bildet.

## Claims

1. Electrical assembly (10) comprising a cooling module (11), notably an active cooling module (11) comprising a cooling-liquid circulation network, and a busbar (12), said busbar (12) being directly attached to a receiving portion (110) of the cooling module (11), said electrical assembly (10) being intended to be fitted in a frame (2) of a first item of electrical equipment (1),
said electrical assembly additionally comprising a power electronics module (20) attached to a first surface (114) of the cooling module (11) and a connecting capacitive element (30) attached to a second surface (115), opposite the first surface (114), of the cooling module (11),
the cooling module having a first portion (118) comprising the first and the second surface (114, 115), the assembly being **characterized in that**
said receiving portion (110) forms a fork extending from the first portion (118) of the cooling module (11), the busbar (12) comprising a first part (124) held between two arms (116, 117) of the fork.

2. Assembly according to Claim 1, wherein said receiving portion (110) comprises opposite faces which are respectively in the same plane as the first surface (114) of the cooling module (11) and as the second surface (115) of the cooling module (11).

3. Electrical assembly according to Claim 1 or 2, wherein the busbar (12) comprises a transverse arm (125) extending from one side of the first part (124), said transverse arm (125) being situated at the junction between the fork and the first portion (118) of the cooling module (11),
said transverse arm (125) extending along the first surface of the cooling module (11) and comprising connection terminals (123) which face terminals of said power module (20) in order to be connected thereto.

4. Electrical assembly (10) according to one of the preceding claims, wherein the cooling module (11) has a cooling-liquid inlet (111) and a cooling-liquid outlet (112), the cooling module (11) being configured such that the cooling liquid circulates between the power electronics module (20) and the connecting capacitive element (30).

5. Electrical assembly (10) according to one of the preceding claims, wherein the busbar (12) comprises a body (121) made of electrically insulating material holding the conductors (122, 123) of the busbar (12) together, said body (121) abutting the cooling module (11) in such a way as to enable thermal dissipation of the heat from the conductors (122, 123) towards the cooling module (11).

6. Item of electrical equipment (1) comprising a casing (2) which accommodates an electrical assembly (10) according to one of the preceding claims.

7. Item of electrical equipment (1) according to Claim 6, forming an inverter.
